**Europäisches Patentamt**

**European Patent Office**

**Office européen des brevets**

(11) Veröffentlichungsnummer: **0 430 288 A2**

# (12) EUROPÄISCHE PATENTANMELDUNG

(21) Anmeldenummer: **90122992.2**

(22) Anmeldetag: **30.11.90**

(51) Int. Cl.⁵: **G01D 5/34**

(30) Priorität: **30.11.89 DE 3939620**

(43) Veröffentlichungstag der Anmeldung:
**05.06.91 Patentblatt 91/23**

(84) Benannte Vertragsstaaten:
**AT BE CH DE DK ES FR GB GR IT LI LU NL SE**
**Patentblatt**

(71) Anmelder: **MICROTAP GMBH**
**Wallbergstrasse 5**
**W-8028 Taufkirchen(DE)**

(72) Erfinder: **Schürr, Werner**
**Mettenstrasse 36**
**W-8000 München 19(DE)**

(74) Vertreter: **Vogeser, Werner, Dipl.-Ing. et al**
**Patentanwälte + Rechtsanwälte Hansmann,**
**Vogeser, Boecker & Alber**
**Albert-Rosshaupter-Strasse 65**
**W-8000 München 70(DE)**

(54) **Drehwinkelgeber.**

(57) Die Erfindung betrifft einen Drehwinkelgeber, insbesondere für Schrittmotoren, bestehend aus einer drehbaren Codierscheibe und einer stationären Befestigungsscheibe, auf der eine Lichtschrankenanordnung und eine dieser zugeordnete Auswertschaltung angeordnet sind, Um diesen Drehwinkelgeber möglichst kompakt auszugestalten, besteht die Lichtschrankenanordnung aus einzelnen Reflexionslichtschranken, die mit reflektierenden Codeelementen auf der Codierscheibe zusammenwirken.

EP 0 430 288 A2

# DREHWINKELGEBER

Die Erfindung betrifft einen Winkelgeber entsprechend dem Oberbegriff des Anspruchs 1.

Derartige Winkelgeber dienen z.B. sowohl zur Steuerung von Schrittmotoren selbst, als auch zur Steuerung von Stellgliedern, deren Betrieb von der Drehlage eines Schrittmotors abhängt.

Es sind Drehwinkelgeber bekannt, bei denen auf der Welle eines Schrittmotors eine Codierscheibe sitzt, die transparente Codeelemente hat. Mit diesen Elementen wirken auf einer stationären Befestigungsscheibe sitzende Sendedioden und auf einer weiteren stationären Befestigungsscheibe sitzende Empfangsdioden zusammen. Weiterhin ist auf einer dieser Befestigungsscheiben oder auch auf einer weiteren Befestigungsscheibe eine Auswerteschaltung vorgesehen. Dieser Aufbau hat in Richtung der Motorwellenachse eine relativ große Erstreckung zur Folge, was für viele Anwendungsfälle ungünstig ist.

Der Erfindung liegt die Aufgabe zugrunde, einen Winkelgeber mit möglichst kompaktem Aufbau zu schaffen.

Gelöst wird diese Aufgabe gemäß der Erfindung durch die im kennzeichnenden Teil des Anspruchs 1 angegebenen Merkmale. Zweckmäßige Ausgestaltungen der Erfindung ergeben sich aus den Unteransprüchen.

Durch die Verwendung von Reflexionslichtschranken kann erreicht werden, daß der gesamte Winkelgeber auf zwei Scheiben untergebracht werden kann, von denen die Codierscheibe reflektierende Codeelemente und die Befestigungsscheibe die Lichtschrankenanordnung und die Auswerteschaltung trägt. Dieser kompakte Aufbau ermöglicht es, den gesamten Winkelgeber in das Gehäuse eines Motors zu integrieren.

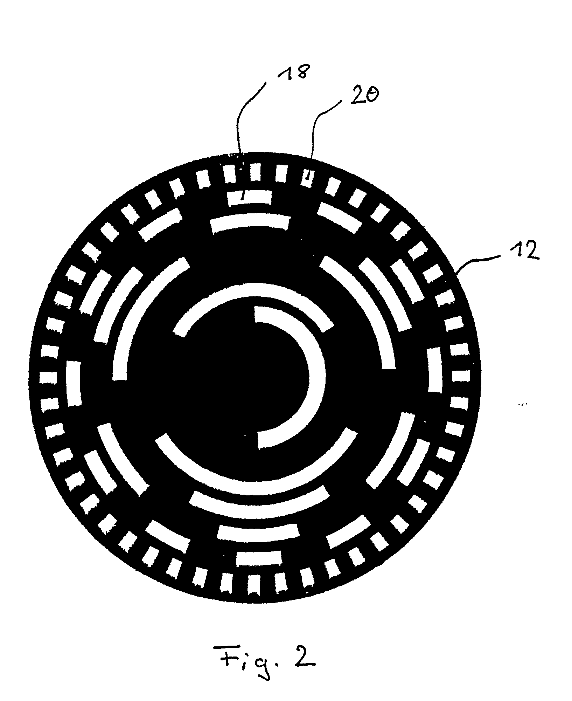

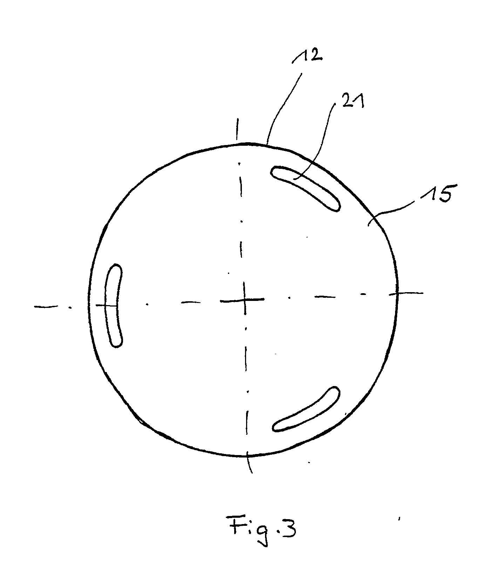

Die Erfindung wird nachstehend anhand der Fig. 1 bis 3 beispielsweise erläutert. Es zeigt:

Fig. 1 eine Seitenansicht des Winkelgebers,
Fig. 2 eine Aufsicht der Codierscheibe, und
Fig. 3 eine Aufsicht der Befestigungsscheibe.

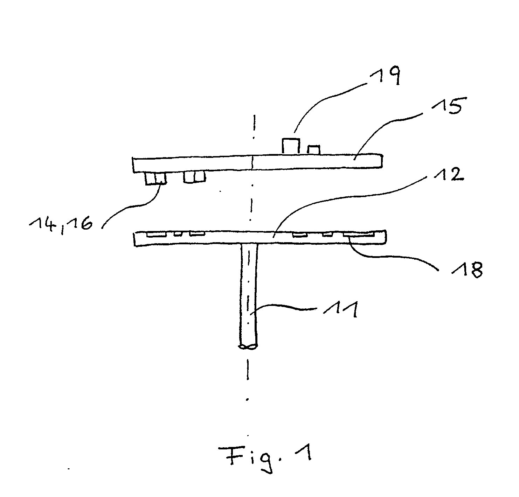

Der Drehwinkelgeber hat, wie Fig. 1 zeigt, eine auf der Welle 11 eines Schrittmotors sitzende Codierscheibe 12, in die z.B. mittels Laser reflektierende Codeelemente 18 in Form eines GRAY-Codes und am Umfang eine Taktspur 20 eingeritzt sind. Die Codeelemente wirken mit Reflexionslichtschranken 14, 16 zusammen, die jeweils aus einer Sende- und einer Empfangsdiode bestehen. Die Lichtschranken sind auf einer stationären Befestigungsscheibe angeordnet, die zweckmäßigerweise aus Aluminium besteht, während die Codierscheibe 12 aus Stahl besteht.

Die Befestigungsscheibe 15 trägt auch eine schematisch dargestellte Auswerteschaltung 19. Sowohl die Lichtschranken 14, 16 als auch die Auswerteschaltung 19 können auf der der Codioerscheibe 12 zugewandten Seite der Befestigugnsscheibe 15 angeordnet sein, und sitzen zweckmäßigerweise auf einer Platine, die mittels Langlöchern 21 in der Befestigungsscheibe 15 zur Codierscheibe 18 einstellbar ist. Der gesamte Drehwinkelgeber kann in das Gehäuse eines nicht gezeigten Schrittmotors eingebaut sein. Bei Anwendung des GRAY-Codes zusammen mit der Taktspur kann der Drehwinkelgeber als Absolutdrehwinkelgeber verwendet werden.

## Ansprüche

1. Drehwinkelgeber, insbesondere für Schrittmotoren, bestehend aus einer drehbaren Codierscheibe und einer stationären Befestigungsscheibe, auf der eine Lichtschrankenanordnung und eine dieser zugeordnete Auswerteschaltung angeordnet sind,
   dadurch **gekennzeichnet**, daß
   die Lichtschrankenanordnung aus einzelnen Reflexionslichtschranken (14, 16) besteht, die mit reflektierenden Codeelementen (18) auf der Codierscheibe (12) zusammenwirken.

2. Drehwinkelgeber nach Anspruch 1,
   dadurch **gekennzeichnet**, daß
   die Codeelemente als GRAY-Code ausgebildet sind, denen eine Taktspur (20) zugeordnet ist.

3. Drehwinkelgeber nach Anspruch 1 oder 2,
   dadurch **gekennzeichnet**, daß
   die Lichtschrankenanordnung und die Auswerteschaltung auf der der Codierscheibe (12) zugewandten Seite der Befestigungsscheibe (15) angeordnet sind.

4. Drehwinkelgeber nach einem der Ansprüche 1 bis 3,
   dadurch **gekennzeichnet**, daß
   die Lichtschrankenanordnung und die Auswerteschaltung auf einer Platine angeordnet sind.

5. Drehwinkelgeber nach Anspruch 4,
   dadurch **gekennzeichnet**, daß
   die Platine bezüglich der Befestigungsscheibe (15) einstellbar ist.

6. Drehwinkelgeber nach einem der Ansprüche 1 bis 5,
   dadurch **gekennzeichnet**, daß

die Codeelemente (18) in die Oberfläche der Codierscheibe (12) eingesetzt sind,

7.  Drehwinkelgeber nach einem der Ansprüche 1 bis 6,
    dadurch **gekennzeichnet**, daß
    die Befestigungsscheibe (15) und die Codierscheibe (12) in das Gehäuse eines zugehörigen Schrittmotors eingebaut sind.

Fig. 1

Fig. 2

Fig.3